# EUROPEAN PATENT APPLICATION

(11) **EP 0 763 855 A2**
(43) Date of publication of application: **19.03.1997**
(21) Application number: 96114639.6
(22) Date of filing: 12.09.1996
(51) Int. Cl.: H01L 29/78, H01L 21/336

(54) **Asymmetrical FET and method of fabrication**

(30) Priority: 18.09.1995 US 3867
(71) Applicant: TEXAS INSTRUMENTS INCORPORATED, Dallas Texas 75265 (US)
(72) Inventor: Chatterjee, Amitava, Plano, TX 75023 (US); Yang, Ping, Richardson, TX 75080 (US); Rodder, Mark, University Park, TX 75225 (US); Chen, Ih-Chin, Richardson, TX 75082 (US)
(74) Representative: Schwepfinger, Karl-Heinz, Dipl.-Ing.

(57) **Abstract**

A transistor and method of forming a transistor. The transistor (10) comprises a source region (20) and a drain region (22) of a first conductivity type located in a substrate (12). The transistor (10) also comprises an asymmetric channel region (24) of a second conductivity type located in the substrate (12) between the source region (20) and the drain region (22). The asymmetric channel region (24) has a lower dopant concentration of the second conductivity type adjacent the source region (20) than adjacent the drain region (22).

## Description

### FIELD OF THE INVENTION

This invention generally relates to semiconductor processing and more specifically to short channel transistors.

### BACKGROUND OF THE INVENTION

Today's smaller transistors (i.e., those having a channel length less than 0.35 microns) tend to suffer from short channel effects. Short channel effects include drain-induced barrier lowering (DIBL) and punch-through. DIBL results in increased leakage current between the source and drain at the surface of the channel, whereas punch-through is current leakage in the bulk area of the transistor below the surface. Methods for reducing the short channel effects as well as hot electron effects must also consider the effect on the performance of the device (e.g., drive current). For example, increasing the dopant concentration throughout the channel suppresses the short channel effects. However, it also increases resistance in the channel region and thus reduces the maximum drive current of the device.

One prior art device developed to reduce hot carrier effects and short channel effects uses a laterally doped channel in which the channel doping has a gradient in the lateral direction which decreases monotonically from the source-edge to the drain edge. This improves the hot carrier reliability due to a reduced substrate current. Punch-through is also somewhat inhibited as the increased dopant concentration at the source side prevents the source side depletion region from widening. However, it is believed that increased dopant concentration at the source side still unacceptably increases resistance and also reduces carrier mobility. Accordingly, there is still a need for an improved transistor design that further suppresses punch-through as well as DIBL without negatively impacting device performance.

### SUMMARY OF THE INVENTION

A transistor and method of forming a transistor is disclosed herein. The transistor comprises a channel region having a source side and a drain side. The concentration of a first conductivity type dopant is less at the source side than at the drain side. The source and drain regions comprise a second conductivity type dopant. The first and second conductivity types are opposite conductivity types. The high dopant concentration at the drain side suppresses the short channel effects, whereas, the lower dopant concentration at the source side maintains the carrier mobility levels and thus does not reduce the maximum drive current.

An advantage of the invention is providing a transistor having reduced short channel effects.

A further advantage of the invention is providing a transistor having reduced short channel effects without degrading device performance.

These and other advantages will be apparent to those of ordinary skill in the art having reference to the specification.

### BRIEF DESCRIPTION OF THE DRAWINGS

The present invention will now be further described, by way of example, with reference to the accompanying drawings in which:
FIG. 1 is a cross-sectional diagram of an asymmetrical transistor according to the invention;
FIG. 2 is a cross-sectional diagram of an asymmetrical transistor according to a first embodiment of the invention;
FIGs. 3 - 6 are cross-sectional diagrams of the asymmetrical transistor of FIG. 2 at various stages of fabrication;
FIG. 7 is a graph illustrating leakage current versus drive current for a prior device and the asymmetrical transistor of FIG. 2;
FIG. 8 is cross-sectional view of an asymmetrical transistor according to a second embodiment of the invention; and
FIGs. 9-11 are cross-sectional diagrams of the asymmetrical transistor of FIG. 8 at various stages of fabrication.

Corresponding numerals and symbols in the different figures refer to corresponding parts unless otherwise indicated.

### DETAILED DESCRIPTION OF PREFERRED EMBODIMENTS

The invention will now be described in conjunction with a short channel nMOS (metal-oxide-semiconductor) transistor. It will be apparent to those of ordinary skill in the art that the benefits of the invention may also be utilized with other types of transistors such as pMOS transistors and transistors having raised source/drains.

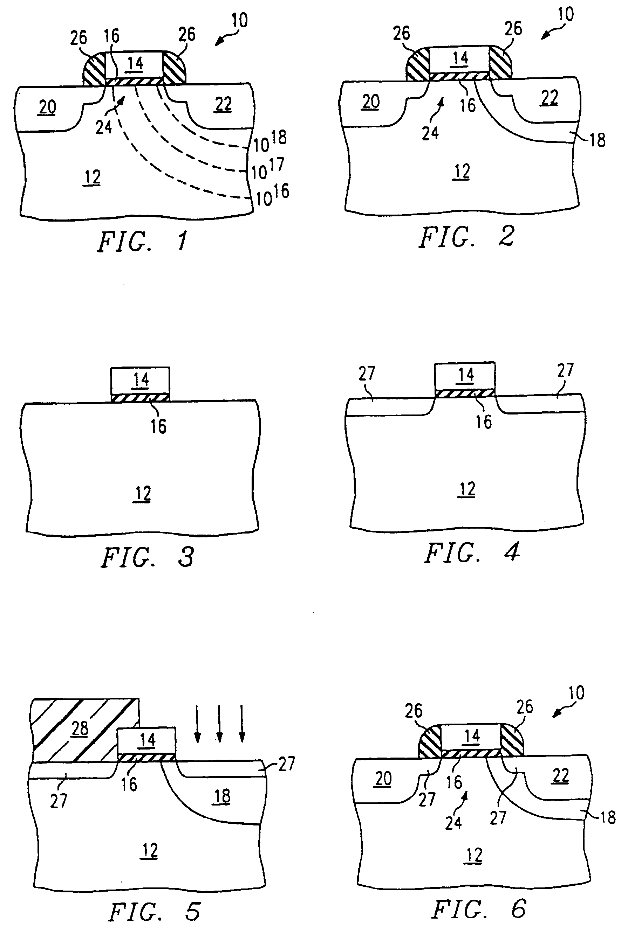

An asymmetrical transistor 10 according to the invention is shown in Figure 1. Transistor 10 is formed in a p-type substrate 12. Of course, p-type substrate 12 may comprise a p-type epitaxial layer on a semiconductor substrate. Gate electrode 14 is separated from substrate 12 by a gate dielectric layer 16. Source region 20 and drain region 22 are formed in substrate 12 and, for an nMOS transistor, comprise a n-type dopant. Channel region 24 has a higher p-type dopant concentration on the drain side than on the source side. For example, if the dopant concentration near drain region 22 is on the order of 1E18, then near the center of channel region 24, the dopant concentration may be on the order of 1E17 and near source region 20, the dopant concentration may be on the order of 1E16. The dopant concentrations discussed above are only given to provide a better understanding of the invention and are not meant to be construed in a limiting sense.

A channel region having a lower dopant concentration at a source side relative to a drain side has several advantages. First, the resistance at the source side of channel region 24 is not increased because there is no additional p-type dopant adjacent to and in the source region 20. For the same reason, the carrier mobility in the channel region near the source is not reduced and the drive current of transistor 10 is not degraded. Second, the short channel effects of DIBL and punch-through are suppressed. Increased dopant concentration on the drain side of channel region 24 inhibits the drain depletion region from widening. Thus, the drain depletion region does not extend to source region 20 and punch-through is suppressed. Increased p-type doping at the surface of the channel region 24 adjacent drain region 22 inhibits current leakage due to DIBL.

There are various methods for forming channel region 24. In a first embodiment of the invention, a p-type doped region 18 is located adjacent drain region 22 of transistor 10, as shown in Figure 2. P-type region 18 has a higher dopant concentration than substrate 12 but a lower dopant concentration than drain region 22. P-type region 18 provides an increased concentration of p-type dopant adjacent drain region 22 in the channel region 24 relative to the source side of the channel region 24. The above described benefits of punch-through and DIBL suppression without negatively impacting performance are thus achieved.

A method for forming the asymmetrical transistor 10 according to the first embodiment of the invention will now be described. First, the device is fabricated through the formation of gate electrode 14, as shown in Figure 3. At this point, drain extension regions 27 may be formed as shown in Figure 4. For example, a n-type dopant such as arsenic or phosphorus may be implanted to a concentration on the order of 1E18 to 1E20/cm³. Drain extension regions 27 are optional and need not be formed to practice the invention.

Next, a masking layer 28 is formed that exposes the area of substrate 12 where the drain region is to be formed as shown in Figure 5. A p-type dopant may then be implanted into the exposed region to form p-type doped region 18. For example, boron may be implanted at a dose in the range of 4 x 10¹² cm⁻² to 8 x 10¹² cm⁻² at an energy on the order of 10 keV - 25 keV. If desired, the p-type dopant may be implanted at an angle. Of course, other methods of forming doped region 18, such as diffusion from an overlying layer, will be apparent to those skilled in the art.

The dopant concentration of p-type doped region 18 is greater than the substrate dopant concentration but less than the dopant concentration of the subsequently formed drain region 22. For example, if the drain region 22 has a dopant concentration on the order of 1E19-1E20 and the substrate dopant concentration is on the order of 1E16-1E18, the dopant concentration of p-type doped region 18 may be on the order of 1E16-1E19.

If drain extension regions 27 were not previously formed, they may be formed after the formation of p-type doped region 18. As mentioned above, drain extension regions 27 are optional and need not be formed to practice the invention.

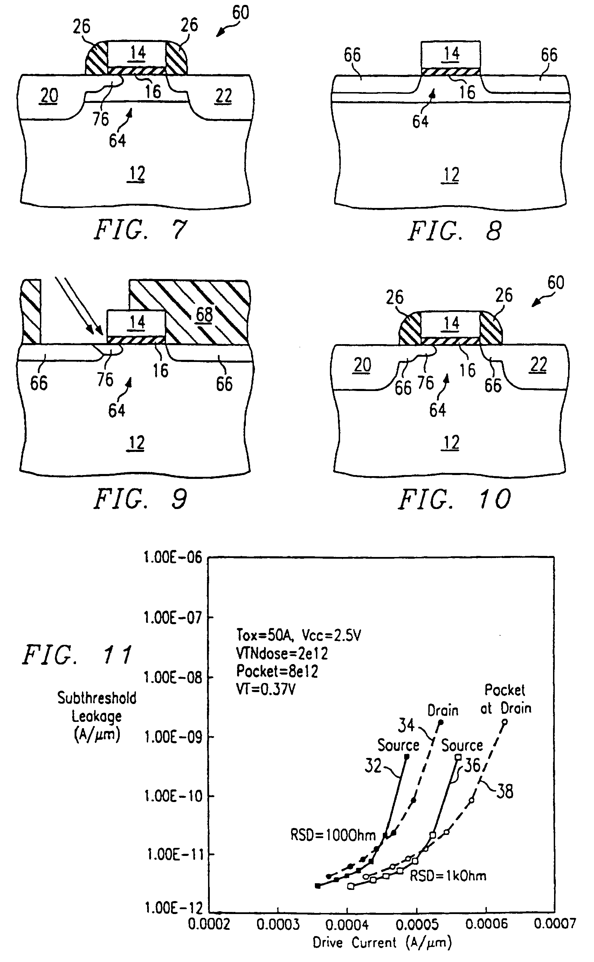

At this point, sidewall spacers 26 may be formed on the sidewalls of gate electrode 14, as shown in Figure 6. Sidewall spacers 26 typically comprise a dielectric material such as silicon-oxide or silicon-nitride. Other suitable materials will be apparent to those skilled in the art. Many techniques and structures are known in the art for forming sidewall spacers. For example, multiple sidewall spacers may be used. A thin oxide (e.g., 150 - 250 Angstroms) may be formed prior to forming drain extension regions 27 either before or after the asymmetric implant followed by a second sidewall formation like the one described above. In addition there may be a brief (50-100 Angstroms) polysilicon re-oxidation immediately following the gate etch.

After sidewall spacers 26 are formed, source region 20 and drain region 22 are formed, for example, by ion implantation. Source region 20 and drain region 22 comprise n-type dopants. The dopant concentration will vary by design and may, for example, be in the range of 1E18 to 1E20/cm³.

Figure 7 is a graph illustrating leakage current versus drive current for the source and drain of a conventional nMOS transistor (32, 34) and the source and drain of a nMOS transistor according to the first embodiment of the invention (36,38) including drain extension regions 27. The conditions used to obtain the data of this graph included the following: oxide thickness of 50 angstroms, drain voltage of 2.5 V, threshold adjust implant dose of 2E12/cm², implant dose for region 18 of 8E12/cm², and a threshold voltage of 0.37 V. The graph indicates that for a given subthreshold leakage current, the transistor according to the first embodiment of the invention has a higher drive current.

A second embodiment of the invention is shown in Figure 8. Instead of an additional p-type doped region 18, the channel region 64 is counterdoped with n-type dopants on the source side (region 76). Accordingly, as in the first embodiment, the channel region 64 has a lower concentration of p-type dopant on the source side relative to the drain side.

A method for forming transistor 60 according to the second embodiment of the invention will now be described. Again, the device is processed through the formation of gate electrode 14. A threshold adjust implant is preferably performed to adjust the dopant concentration of the channel region 64. At this point, drain extension regions 66 may be formed as shown in Figure 9. For example, a n-type dopant such as arsenic or phosphorus may be implanted to a concentration on the order of 1E18 to 1E20/cm³. Drain extension regions 66 are optional and need not be formed to practice the invention.

Next, a masking layer 68 is formed that exposes the area of substrate 12 where the source region 20 is to be formed. A n-type dopant is then implanted into the exposed region to form region 76 as shown in Figure 10. For example, arsenic or phosphorous may be implanted at a dose in the range of 2x10¹² - 6x10¹² cm⁻² at an energy on the order of 30 - 100 keV. Preferably, the n-type dopant is implanted at an angle so that the dopant is implanted under the gate electrode 14.

The implant dose is such that region 76 remains p-type even though n-type dopants are being implanted. Accordingly, dopant concentration of n-type dopant is less than that of the channel region 64. For example, if the dopant concentration of channel region 64 is typically in the range of 1E16 to 1E18/cm³, the concentration of n-type dopant at the source side of channel region 64 may be on the order of 1E15 to 1E17/cm³.

If drain extension regions 66 were not previously formed, they may be formed at this point. As mentioned above, drain extension regions 66 are optional and need not be formed to practice the invention.

At this point, sidewall spacers 26 are formed on the sidewalls of gate electrode 14, as shown in Figure 10. Sidewall spacers 26 typically comprise a dielectric material such as silicon-oxide or silicon-nitride. Other suitable materials will be apparent to those skilled in the art. Then, source region 20 and drain region 22 are formed, for example, by ion implantation. Source region 20 and drain region 22 comprise n-type dopants. The dopant concentration will vary by design and may, for example, be in the range of 1E18 to 1E20/cm³.

It will be apparent to those skilled in the art that if a pMOS transistor is desired, the conductivity types discussed above would be reversed.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A method of forming a transistor comprising the steps of:
forming a gate electrode on a substrate;
forming a source region and a drain region in said substrate on opposite sides of said gate electrode; and
forming an asymmetric channel region between said source region and said drain region wherein said asymmetric channel region has a lower dopant concentration adjacent said source region than adjacent said drain region.

2. The method of Claim 1, wherein said step of forming said asymmetric channel region comprises the step of:
forming a doped region in said substrate adjacent said drain region.

3. The method of claim 2, wherein said step of forming said doped region comprises forming a doped region having a dopant concentration between a dopant concentration of said substrate and a dopant concentration of said drain region.

4. The method of Claim 2 or Claim 3, wherein said step of forming said doped region comprises implanting a dopant of said first conductivity type.

5. The method of Claim 4, wherein said implanting step is an angled implant.

6. The method of any preceding claim comprising; providing a substrate having a first conductivity type and forming source and drain regions having a second conductivity type opposite the first conductivity type.

7. The method of any preceding claim comprising; forming the asymmetric channel region having a lower concentration of said first conductivity type dopant adjacent said source region.

8. The method of any preceding claim, wherein said step of forming said asymmetric channel region comprises the step of:
counterdoping a portion of said substrate below said gate electrode adjacent said source region with said second conductivity type dopant.

9. The method of any preceding claim, further comprising providing a substrate wherein said portion of said substrate is of said first conductivity type and having a dopant concentration level less than a dopant concentration of said substrate.

10. A method of forming a transistor comprising the steps of:
forming a gate electrode on said substrate;
forming an asymmetric channel region below said gate electrode, said asymmetric channel region having a source side and a drain side, wherein said source side has a lower dopant concentration than said drain side;
forming a source region on said source side of said channel region and a drain region of said drain side of said channel region.

11. The method of Claim 10, wherein said step of forming said asymmetric channel region comprises the step of forming a doped region adjacent said gate electrode on said drain side.

12. The method of Claim 11, wherein the step of forming the doped region comprises forming a doped region having a dopant concentration between a dopant concentration of said substrate and a dopant concentration of said drain region.

13. The method of Claim 11 or Claim 12, wherein said method of forming said doped region comprises implanting a dopant of said first conductivity type.

14. The method of Claim 13, wherein said implanting step is an angled implant.

15. The method of any of Claims 10 to 14 comprising; providing a substrate having a first conductivity type and forming source and drain regions having a second conductivity type opposite the first conductivity type.

16. The method of any of Claims 10 to 15, wherein said step of forming said asymmetric channel region comprises the step of:
counterdoping a portion of said substrate below said gate electrode adjacent on said source side with said second conductivity type dopant.

17. The method of any of Claims 10 to 16, further comprising; providing a substrate having said portion of said substrate of said first conductivity type and having a dopant concentration level less than a dopant concentration of said substrate.

18. A transistor comprising:
a source region located in a substrate;
a drain region located in said substrate; and
an asymmetric channel region located in said substrate between said source region and said drain region wherein said asymmetric channel region has a lower dopant concentration adjacent said source region than adjacent said drain region.

19. The transistor of Claim 18, wherein said source and drain regions are of a first conductivity type, and said channel region is of a second conductivity type.

20. The transistor of Claim 18 or Claim 19, wherein said asymmetric channel region comprises a doped region of second conductivity type adjacent said drain region.

21. The transistor of Claim 20, wherein said doped region has a dopant concentration greater than said substrate and less than said drain region.

22. The transistor of any of Claim 18 to 21, wherein said asymmetric channel region comprises a counterdoped region adjacent said source region.
